**Europäisches Patentamt**

**European Patent Office**

**Office européen des brevets**

(19)

(11) Veröffentlichungsnummer: **0 146 860**
**B1**

(12) # EUROPÄISCHE PATENTSCHRIFT

(45) Veröffentlichungstag der Patentschrift:
**08.03.89**

(21) Anmeldenummer: **84115048.5**

(22) Anmeldetag: **10.12.84**

(51) Int. Cl.⁴: **H 03 D 3/08**, H 03 L 7/04,
H 03 C 3/09

(54) Breitbandiger Frequenzdiskriminator.

(30) Priorität: **12.12.83 DE 3344867**

(43) Veröffentlichungstag der Anmeldung:
**03.07.85 Patentblatt 85/27**

(45) Bekanntmachung des Hinweises auf die Patenterteilung:
**08.03.89 Patentblatt 89/10**

(84) Benannte Vertragsstaaten:
**AT CH DE GB IT LI NL**

(56) Entgegenhaltungen:
**DE-A-1 816 907**
**DE-A-2 606 138**
**DE-B-1 070 695**
**US-A-3 956 706**

(73) Patentinhaber: **Siemens Aktiengesellschaft Berlin
und München, Wittelsbacherplatz 2, D-8000
München 2 (DE)**

(72) Erfinder: **Müller, Friedrich, Dipl.- Ing.,
Maxhofstrasse 74, D-8000 München 71 (DE)**

EP 0 146 860 B1

**Beschreibung**

Die Erfindung bezieht sich auf einen breitbandigen Frequenzdiskriminator zur Stabilisierung von Mikrowellenoszillatoren, mit einem 3 dB-Koppler, dessen Eingang das Radiofrequenzsignal (RF-Signal) zugeführt wird und dessen beide Ausgänge mit Koppeleinrichtungen verbunden sind, über die die phasenverschobenen Ausgangssignale des Kopplers jeweils in den Leitungszweig des anderen Ausgangs geführt und einem im jeweiligen Leitungszweig eingeschalteten Detektor zugeführt werden. Solche frequenzstabile Oszillatoren sind für Richtfunksysteme vorgesehen, wo sie als Lokaloszillatoren in Empfängern oder als direkt modulierte Oszillatoren in Sendern verwendet werden.

Durch die DE-A-2 608 138 ist ein stabilisierter Oszillator mit einem spannungsgeregelten Oszillator, dessen Frequenz in einer Frequenzregelschleife nachgeregelt wird, bekannt, bei dem in der Frequenzregelschleife ein Resonator angeordnet ist und eine diesem parallelgeschaltete Ausgleichsschaltung. Dieser wird ein mittels einer vor dem Resonator angeordneten Auskoppelvorrichtung ausgekoppelter Teil des Signals der Frequenzregelschleife zugeführt. Der Resonator und das Ausgleichsglied sind ausgangsseitig über einen 3 dB-Koppler miteinander verbunden, dem ein Detektor und ein ausgangsseitig mit dem spannungsgeregelten Oszillator verbundener Regelverstärker nachgeschaltet sind. Der hierin vorgesehene Frequenzdiskriminator beruht darauf, daß im Bereich der Resonanzfrequenz des Resonators dessen Phasenänderung groß gegen die Phasenänderung des Leitungsstückes ist. Damit ergibt sich für eine Länge L bei verschiedenen Resonatorfrequenzen ein zum Nullpunkt symmetrischer Spannungsverlauf am Ausgang der Detektordioden. Im Resonanzfall müssen die Spannungsphasen an den Eingängen des 3 dB Kopplers gleich sein, um an den Detektordioden gleiche Spannungen und damit am Ausgang des Regelverstärkers Null Volt zu erzeugen. Eine symmetrische Frequenz-Spannungscharakteristik ist in einem größeren Frequenzbereich nur mit einer Korrektur der Ausgleichsleitung und/oder der Resonatorankopplungen zu erreichen. Zur Stabilisierung eines frequenzmodulierten Oszillators ist jedoch ein symmetrischer Diskriminator erforderlich, da die Modulationsseitenbänder sonst eine von Null Volt abweichende mittlere Diskriminatorspannung erzeugen, die mit Modulation eine andere mittlere Sendefrequenz hervorruft als ohne Modulation.

Ein Frequenzdiskriminator der eingangs beschriebenen Art ist aus der US-A-3 956 706 bekannt. Bei diesem erfolgt in einem ersten Leistungsteiler eine Aufteilung eines Eingangssignals in zwei gleiche, 180° phasenverschobene Ausgangssignale, die dann einem zweiten bzw. dritten Leistungsteiler zugeführt werden. Die Ausgänge dieser beiden, aus jeweils einem 180°-Hybrid bestehenden Leistungsteiler sind mit einem nachfolgenden 180°-Hybrid und einem 90°-Hybrid derart verbunden, daß jeweils ein Ausgang des zweiten und dritten Leistungsteilers mit den beiden Eingängen des 180°-Hybrid und der jeweils zweite Ausgang der beiden Leistungsteiler mit den beiden Eingängen des 90°-Hybrid verbunden ist. In den beiden Ausgangszweigen des 180°-Hybrid und des 90°-Hybrid ist jeweils ein Detektor angeordnet, die an die Eingänge eines Differenzverstärkers angeschlossen sind.

Der Erfindung liegt die Aufgabe zugrunde, einen in seinem Aufbau einfachen Frequenzdiskriminator zu schaffen, mit dem eine Breitbandabstimmung von Oszillatoren in einem möglichst breiten Frequenzband durchführbar ist.

Diese Aufgabe wird gemäß der Erfindung in der Weise gelöst, daß im Verbindungsweg zwischen den beiden Leitungszweigen ein Durchgangsresonator oder eine Durchgangsleitung mit angekoppeltem Parallelresonator angeordnet ist, denen die phasenverschobenen Ausgangssignale des als 3 dB/90°-Koppler ausgebildeten Kopplers über die jeweilige Koppeleinrichtung zugeführt werden.

Vorteilhafte Ausgestaltungen und Weiterbildungen des Erfindungsgegenstandes sind in den Unteransprüchen angegeben.

Nachstehend wird die Erfindung anhand von in der Zeichnung dargestellten Ausführungsbeispielen näher erläutert.

Es zeigen
Fig. 1 und 2 jeweils einen Frequenzdiskriminator im Blockschaltbild mit Zirkulatoren als Koppeleinrichtungen,
Fig. 3 ein Diagramm der Diodenausgangsspannungen,
Fig. 4 einen Frequenzdiskriminator mit einem Richtungsfilter als Koppeleinrichtung,
Fig. 5 und 6 jeweils einen Frequenzdiskriminator in integriertem Schaltungsaufbau,
Fig. 7 eine weitere Ausführungsform eines Frequenzdiskriminators im Blockschaltbild und
Fig. 8 eine Schaltung zur automatischen Hubregelung eines diskriminatorstabilisierten Oszillators.

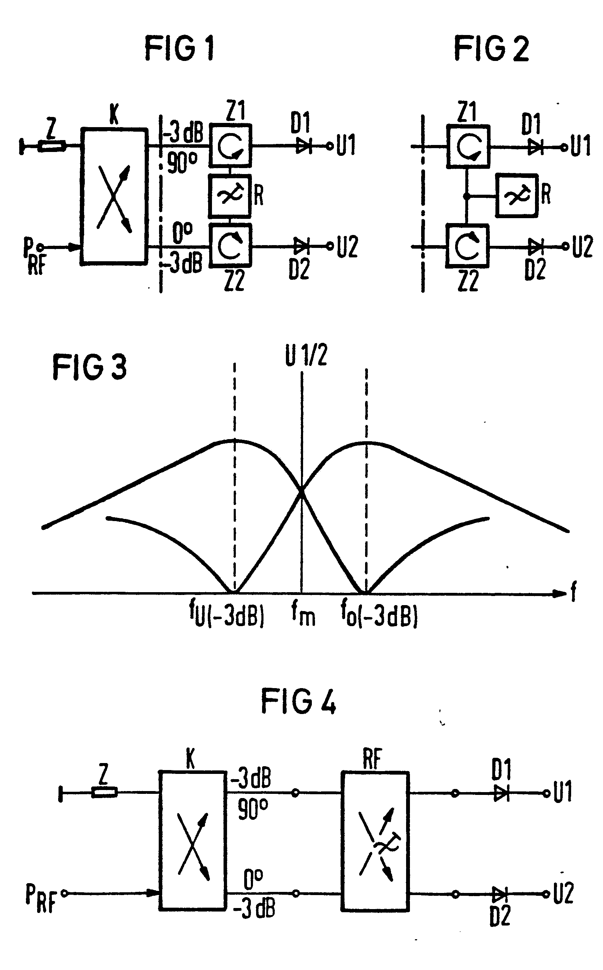

Der Frequenzdiskriminator nach Fig. 1 besteht aus einem 3 dB/90°-Koppler K, dem eingangsseitig das RF-Signal P zugeführt wird und an dessen beide Ausgänge jeweils ein Zirkulator Z1, Z2 angeschlossen ist, an deren in Übertragungsrichtung folgend jeweils zweitem Anschluß jeweils eine Detektordiode D1, D2 angeschaltet ist, deren Ausgangsspannungen mit U1, U2 bezeichnet sind. Die Anschlüsse der Zirkulatoren Z1, Z2, die den mit dem Koppler K verbundenen Anschlüssen in Übertragungsrichtung der Zirkulatoren unmittelbar folgen, sind über einen Resonator R (Durchgangsresonator) miteinander verbunden. Der Resonator R kann dabei fest eingestellt oder abstimmbar ausgebildet sein.

Der Frequenzdiskriminator nach Fig. 2 entspricht im grundsätzlichen Aufbau dem in Fig. 1. Unterschiedlich ist lediglich, daß der Resonator R nicht in der Verbindungsleitung zwischen den beiden Zirkulatoren Z1, Z2 eingeschaltet ist, sondern daß die beiden Zirkulatoren Z1, Z2 über eine Durchgangsleitung miteinander verbunden sind, an die der Resonator R als Parallelresonator angekoppelt ist.

Bei den vorstehend beschriebenen Anordnungen wird die Eingangsleistung P im Koppler K in zwei gleiche, aber um 90° gegeneinander phasenverschobene HF-Spannungen aufgeteilt. Beide Spannungen werden in gegenläufiger Richtung dem Durchgangsresonator R (vgl. Fig. 1) oder der Durchgangsleitung mit angekoppeltem Parallelresonator R (vgl Fig. 2) zugeführt und vom jeweils gegenüberliegenden Detektor D1, D2 angezeigt (Resonanzfall). Außerhalb der Resonanz, z. B. in den 3 dB-Punkten, erhalten die Detektoren D1, D2 zwei gleichgroße HF-Spannungen aus dem 0°- und 90°-Arm. Die eine Spannung entsteht durch Reflexionsdämpfung (3 dB) der 90°-Teilspannung am Resonator, die andere durch die Durchgangsdämpfung (3 dB) der 0°-Teilspannung. Die Phasendifferenz der Teilspannungen ist am einen Detektor gerade 180° (Auslöschung), am anderen Detektor gerade 0° (Addition). Bei anderen Frequenzen ergeben sich die dazwischenliegenden Spannungswerte. Die typischen Diodenausgangsspannungen U1 und U2 sind in Fig. 3 dargestellt. Die Subtraktion beider Spannungen (Differenz der Spannungen U1 und U2) ergibt die aus der Literatur bekannte Diskriminatorkennlinie.

Der Frequenzdiskriminator nach Fig. 4 besteht aus einem 3 dB/90°-Koppler K, einem nachfolgenden abstimmbaren Richtungsfilter RF und zwei in die Ausgangszweige des Richtungsfilters RF eingeschalteten Detektoren D1, D2, denen ausgangsseitig die Spannung U1 bzw. U2 entnehmbar ist. Im Unterschied zu den Ausführungsformen nach Fig. 1 und 2 entfallen hierbei die Zirkulatoren. Die Funktion ist jedoch ähnlich wie bei den vorstehend beschriebenen Ausführungsformen, wobei sich ebenfalls eine entsprechende Diskriminatorcharakteristik ergibt.

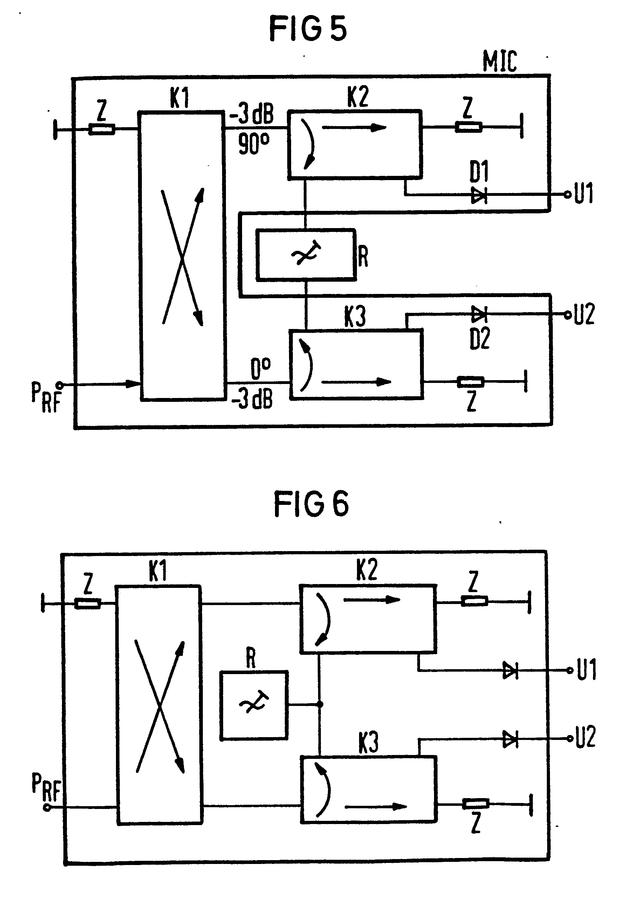

Die Frequenzdiskriminatoren nach Fig. 5 und 6 bestehen aus einem 3 dB/90°-Koppler K1, zwei weiteren, in die Ausgangszweige des Kopplers K1 eingeschalteten Richt-Kopplern K2, K3 mit beliebigen, aber gleichen Koppeldämpfungen, mit jeweils einem Abschlußwiderstand Z, einem abstimmbaren Grundwellenresonator R im Verbindungsweg zwischen den beiden Richt-Kopplern K2, K3 und zwei Detektordioden D1, D2, die in Ausgangszweig der Richt-Koppler K2 bzw. K3 eingeschaltet sind. Die gesamte Anordnung ist dabei jeweils als integrierte Mikrowellenschaltung aufgebaut, die durch den strichliert umrandeten Bereich markiert ist.

Der Grundwellenresonator R ist bei der Ausführungsform nach Fig. 5 als Serienresonator (Durchgangsresonator) außen an die Mikrowellenschaltung angeflanscht. Hierbei kann der Resonator selbstverständlich auch als Parallelresonator angeschaltet sein.

Bei der Ausführungsform nach Fig. 6 ist der Resonator (hierbei als Parallelresonator dargestellt) zum Beispiel aus dielektrischem Material in die Gesamtschaltung integriert. Als äußere Anschlüsse der MIC-Schaltung sind die Eingangsklemme für das RF-Signal P und für die Ausgangsspannungen U1, U2 herausgeführt. Die Wirkungsweise dieser Frequenzdiskriminatoren und deren Frequenz-Spannungscharakteristik entsprechen denen der vorstehend bereits beschriebenen Ausführungsformen.

Fig. 7 zeigt einen Frequenzdiskriminator, der in seinem Grundaufbau dem in Fig. 5 dargestellten entspricht. An die Stelle der Kopplerabschlußwiderstände Z der Richt-Koppler K2, K3 ist hierbei ein weiterer 3 dB-Koppler K4 getreten, der die im ersten Koppler K1 aufgeteilte Leistung wieder summiert. Am Ausgang des weiteren Kopplers K4 ist somit das RF-Signal P entnehmbar.

Bei der Schilderung des Standes der Technik nach der DE-A-2 608 138 A1 wurde bereits ausgeführt, daß Diskriminatoren als Regelglied zur Frequenzstabilisierung von Oszillatoren (VCO) verwendet werden. Fig. 8 zeigt eine Schaltung zur automatischen Hubregelung eines diskriminatorstabilisierten Oszillators bei analoger oder digitaler Frequenzmodulation. Dabei sind dem Diskriminator DIS ausgangsseitig zwei Operationsverstärker OP1, OP2 parallel angeschaltet. Der Ausgang des Operationsverstärkers OP2 ist über einen Gleichrichter GR an einen Modulationsverstärker MV angeschlossen, an dem ein Modulationssignal $U_{mod}$ (1) anliegt. Der Ausgang des Modulationsverstärkers MV ist über ein Filterglied F, an das auch der Ausgang des Operationsverstärkers OP1 angeschlossen ist, an das Stellglied des zu stabilisierenden Oszillators (VCO) angeschaltet.

Bei zusätzlicher Frequenzmodulation erscheint am Ausgang des Diskriminators DIS das dem Oszillator aufmodulierte Signal $U_{mod}$ (1) als demoduliertes Signal wieder. Es wird im Operationsverstärker OP2 verstärkt ($U_{mod\ (2)}$), im Gleichrichter GR gleichgerichtet und dem Modulationsverstärker MV als Regelgröße zugeführt. Damit wird für jede Frequenz des Oszillators dessen Änderung der Abstimmsteilheit ausgeregelt.

## Patentansprüche

1. Breitbandiger Frequenzdiskriminator zur Stabilisierung von Mikrowellenoszillatoren mit einem 3 dB-Koppler (K; K₁) dessen Eingang das Radiofrequenzsignal (RF-Signal) zugeführt wird und dessen beide Ausgänge mit Koppeleinrichtungen verbunden sind, über die die phasenverschobenen Ausgangssignale des Kopplers jeweils in den Leitungszweig des anderen Ausgangs geführt und einem im jeweiligen Leitungszweig eingeschalteten Detektor zugeführt werden, dadurch gekennzeichnet, daß im Verbindungsweg zwischen den beiden Leitungszweigen ein Durchgangsresonator (R) oder eine Durchgangsleitung mit angekoppeltem Parallelresonator (R) angeordnet ist, denen die phasenverschobenen Ausgangssignale des als 3 dB/90°-Koppler ausgebildeten Kopplers (K; K1) über die jeweilige Koppeleinrichtung zugeführt werden.

2. Frequenzdiskriminator nach Anspruch 1, dadurch gekennzeichnet, daß die Koppeleinrichtungen aus jeweils einem Zirkulator (Z1, Z2) bestehen.

3. Frequenzdiskriminator nach Anspruch 1, dadurch gekennzeichnet, daß die Koppeleinrichtungen aus jeweils einem Richtkoppler (K2, K3) bestehen.

4. Frequenzdiskriminator nach einem der Ansprüche 1 bis 3, gekennzeichnet durch den Aufbau in gedruckter Schaltungstechnik mit integriertem Parallel- oder Serienresonator (R).

5. Frequenzdiskriminator nach einem der Ansprüche 1 bis 3, gekennzeichnet durch den Aufbau in gedruckter Schaltungstechnik mit einem außen angeflanschten Parallel- oder Serienresonator (R).

6. Frequenzdiskriminator nach Anspruch 1, dadurch gekennzeichnet, daß die Koppeleinrichtungen aus einem Richtungsfilter (RF) bestehen, dessen beide Eingänge mit den Ausgängen des 3 dB/90°-Kopplers (K) verbunden sind und in dessen beide Ausgangszweige jeweils ein Detektor (D1, D2) eingeschaltet ist.

7. Frequenzdiskriminator nach Anspruch 6, dadurch gekennzeichnet, daß das Richtungsfilter (RF) abstimmbar ausgebildet ist.

8. Frequenzdiskriminator nach einem der vorhergehenden Ansprüche, gekennzeichnet durch seine Verwendung für die automatische Hubregelung eines diskriminatorstabilisierten Oszillators (VCO), indem an den Oszillatorausgang der Frequenzdiskriminator angeschlossen ist, dem ausgangsseitig zwei Operationsverstärker parallel angeschaltet sind, von denen der eine (OP2) über einen Gleichrichter (GR) mit einem Modulationsverstärker (MV) verbunden ist, dem ein Modulationssignal (U$_{mod (1)}$) zugeführt wird und der ausgangsseitig über ein Filterglied (F), das zudem mit dem Ausgang des anderen Operationsverstärkers (OP1) verbunden ist, an den Oszillator (VCO) angeschlossen ist.

## Claims

1. Wide-band frequency discriminator for the stabilization of microwave oscillators, having a 3 dB coupler (K; K₁), to the input of which the radio frequency signal (RF signal) is supplied and the two outputs of which are connected with coupling devices, via which the dephased output signals of the coupler are in each case conducted into the line branch of the other output and supplied to a detector connected in the respective line branch, characterized in that, in the connecting path between the two line branches, a through resonator (R) or a through line with coupled parallel resonator (R) is arranged, to which the dephased output signals of the coupler (K; K1) designed as a 3 dB/90° coupler, are suppled via the respective coupling device.

2. Frequency discriminator according to Claim 1, characterized in that the coupling devices each consist of a circulator (Z1, Z2).

3. Frequency discriminator according to Claim 1, characterized in that the coupling devices each consist of a directional coupler (K2, K3).

4. Frequency discriminator according to one of Claims 1 to 3, characterized by the construction in printed circuit technology with integrated parallel or series resonator (R).

5. Frequency discriminator according to one of Claims 1 to 3, characterized by the construction in printed circuit technology with a parallel or series resonator (R) flanged on externally.

6. Frequency discriminator according to Claim 1, characterized in that the coupling devices consists of a directional filter (RF), the two inputs of which are connected to the outputs of the 3 dB/90° coupler (K) and into both output branches of which a detector (D1, D2) is in each case connected.

7. Frequency discriminator according to Claim 6, characterized in that the directional filter (RF) is designed so as to be capable of tuning.

8. Frequency discriminator according to one of the preceding claims, characterized by its use for the automatic deviation control of a discriminator-stabilized oscillator (VCO), in that the frequency discriminator is connected at the oscillator output, to which frequency discriminator, on the output side, two operational amplifiers are connected in parallel, one of which (OP2) is connected via a rectifier (GR) to a modulation amplifier (MV), to which a modulation signal (U$_{mod (1)}$) is supplied and which is connected on the output side via a filter element (F), which is additionally connected to the output of the other operational amplifier (OP1), to the oscillator (VC0).

## Revendications

1. Discriminateur de fréquence à large bande pour la stabilisation d'oscillateurs à Micro-ondes, comportant un coupleur à 3 dB (K; K1) à l'entrée duquel est envoyé le signal à haute fréquence (signal RF) et dont les deux sorties sont reliées à des dispositifs de couplage, au moyen desquels les signaux de sortie déphasés du coupleur sont envoyés respectivement dans le tronçon de ligne de l'autre sortie et à un détecteur branché dans le tronçon de ligne respectif, caractérisé par le fait qu'un résonateur de transit (R) ou une ligne de transit, à laquelle est accouplé un résonateur parallèle (R), est disposé dans la voie de liaison entre les deux tronçons de ligne, les signaux de sortie déphasés du coupleur (K; K1) réalisé sous la forme d'un coupleur à 3 dB/90° étant envoyés à la ligne et au résonateur par l'intermédiaire du dispositif de couplage respectif.

2. Discriminateur de fréquence suivant la revendication 1, caractérisé par le fait que les dispositifs de couplage sont constitués chacun par un circulateur (Z1, Z2).

3. Discriminateur de fréquence suivant la revendication 1, caractérisé par le fait que les dispositifs de couplage sont constitués chacun par un coupleur directionnel (K2, K3).

4. Diviseur de fréquence suivant l'une des revendications 1 à 3, caractérisé par sa réalisation selon la technique des circuits imprimés, avec un résonateur parallèle ou série (R) intégré.

5. Discriminateur de fréquence suivant l'une des revendications 1 à 3, caractérisé par sa réalisation selon la technique des circuits intégrés imprimés avec un résonateur parallèle ou série (T) raccordé extérieurement par bride.

6. Discriminateur de fréquence suivant la revendication 1, caractérisé par le fait que les dispositifs de couplage sont constitués par un filtre directif (RF), dont les deux entrées sont reliées aux sorties du coupleur (K) à 3 dB/90° et dans les deux branches de sortie duquel sont branchés des détecteurs respectifs (D1, D2).

7. Discriminateur de fréquence suivant la revendication 6, caractérisé par le fait que le filtre directif (RF) est réalisé de manière à être accordable.

8. Discriminateur de fréquence selon l'une des revendications précédentes, caractérisé par son application à la régulation automatique de l'excursion de fréquence d'un oscillateur (VCO) stabilisé par un discriminateur, par le fait qu'à la sortie de l'oscillateur se trouve raccordé le discriminateur de fréquence à la sortie duquel sont branchés, en parallèle, deux amplificateurs opérationnels, dont l'un (OP2) est relié par l'intermédiaire d'un redresseur (GR) à un amplificateur de modulation (MV) auquel est envoyé un signal de modulation ($U_{mod\ (1)}$) et dont la sortie est raccordée à l'oscillateur (VCO) par l'intermédiaire d'un circuit de filtre (F), qui est en outre relié à la sortie de l'autre amplificateur opérationnel (OP1).

## FIG 1

## FIG 2

## FIG 3

## FIG 4

# FIG 5

# FIG 6